# EUROPEAN PATENT APPLICATION

(11) **EP 4 375 395 A1**
(43) Date of publication of application: **29.05.2024**
(21) Application number: 22845135.7
(22) Date of filing: 05.07.2022
(51) Int. Cl.: C23C 16/44, C23C 16/46, C30B 25/08, C30B 25/10

(54) **REACTION CHAMBER AND SEMICONDUCTOR PROCESSING APPARATUS**

(30) Priority: 22.07.2021 CN 202110830608
(71) Applicant: Beijing NAURA Microelectronics Equipment Co., Ltd., Beijing 100176 (CN)
(72) Inventor: LI, Shikai, Beijing 100176 (CN); DONG, Boyu, Beijing 100176 (CN); YUAN, Fushun, Beijing 100176 (CN); WANG, Leilei, Beijing 100176 (CN); LI, Xiaojun, Beijing 100176 (CN); ZHAO, Donghua, Beijing 100176 (CN); LIU, Guangzheng, Beijing 100176 (CN); XU, Keke, Beijing 100176 (CN); LIU, Jingjing, Beijing 100176 (CN); SUN, Xiaoqin, Beijing 100176 (CN); GONG, Zhaohui, Beijing 100176 (CN); JIA, Wanyong, Beijing 100176 (CN); XU, Lifei, Beijing 100176 (CN); DONG, Xue, Beijing 100176 (CN); WANG, Tieran, Beijing 100176 (CN)
(74) Representative: Cohausz & Florack
(86) International application number: PCT/CN2022/103865
(87) International publication number: WO 2023/000970

(57) **Abstract**

The present disclosure provides a reaction chamber and semiconductor processing equipment. The reaction chamber includes an insulating chamber, a first heating body, a second heating body, and an isolation protection structure. The first heating body and the second heating body are arranged at an interval within the insulating chamber. The second heating body is provided with a carrier device for carrying a wafer. The isolation protection structure is arranged within the insulating chamber, located between the first heating body and the second heating body, forms a reaction space, and isolates the first heating body and the second heating body from the reaction space. An opening is arranged on a side of the isolation protection structure close to the second heating body, and the surface of the carrier device is exposed in the reaction space. In the technical solution of the reaction chamber and the semiconductor processing equipment of the present disclosure, the by-product attached to the heating body can be reduced, the equipment maintenance efficiency can be improved, and the equipment maintenance cost can be reduced.

## Description

### TECHNICAL FIELD

The present disclosure generally relates to the semiconductor manufacturing field and, more particularly, to a reaction chamber and semiconductor equipment.

### BACKGROUND

An epitaxial growth refers to a process of growing a single-crystal layer on a single-crystal substrate with a certain requirement and having a same crystal direction as the substrate. Compared to the growth environment for silicon epitaxy, a process environment temperature of silicon carbide epitaxy is higher, typically ranging from 1500°C to 1800°C, with a longer growth period. Currently, chemical vapor deposition (CVD) is mainly used to perform an epitaxial layer growth of silicon carbide.

The existing CVD equipment usually uses a heating member to define a reaction zone, and the reaction zone is heated by using an electromagnetic inductive coil in an induction heating method. However, since the heating zone is defined through the heating member, a reaction by-product that is difficult to remove is attached to the surface of the heating member in contact with the reaction zone. If the chamber environment is recovered, the heating member needs to be replaced, which causes the equipment maintenance rate to be reduced and the equipment maintenance cost to be increased.

### SUMMARY

The present disclosure is intended to solve one of the technical problems in the existing technology and provide a reaction chamber and semiconductor processing equipment, which reduces the by-product attached to a heating body. Thus, a replacement frequency of the heating body can be reduced, equipment maintenance efficiency can be improved, and equipment maintenance cost can be reduced.

To achieve the above purpose, the present disclosure provides a reaction chamber applied to semiconductor processing equipment comprising an insulating chamber, a first heating body, a second heating body, and an isolation protection structure, wherein:
the first heating body and the second heating body are arranged in the insulating chamber at an interval, and a carrier device for carrying a wafer is arranged on the second heating body; and
the isolation protection structure is arranged in the insulating chamber, located between the first heating body and the second heating body, forms a reaction space, and isolates the first heating body and the second heating body from the reaction space, an opening is arranged on a side of the isolation protection structure close to the second heating body and is configured to accommodate the carrier device, and a carrying surface of the carrier device is exposed in the reaction space.

In some embodiments, the isolation protection structure includes a first isolating member, a second isolating member, and a third isolating member, wherein:
the first isolating member is arranged at the second heating body, is configured to cover a surface of the second heating body neighboring to the reaction space, and includes the opening;
the second isolating member is arranged at the first heating body and configured to cover a surface of the first heating body neighboring the reaction space; and
an inlet opening and an outlet opening are arranged on sidewalls on two sides of the insulating chamber, the inlet opening and the outlet opening communicate with the reaction space, two third isolating members are provided, the two third isolating members are arranged on two sides of the carrier device at an interval, and each third isolating member of the two third isolating members connects between the second isolating member and the second heating body and extends along a gas flow direction from the inlet opening to the outlet opening.

In some embodiments, the carrier device includes a rotation table and a carrier plate for carrying the wafer arranged on the rotation table, and the rotation table is located in the opening and rotatably connected to the second heating body through a rotating shaft; and
the rotation table includes a protrusion table, the carrier plate is arranged on the protrusion table, the rotation table includes an edge member protruding relative to an outer peripheral wall of the protrusion table, the first isolating member includes a first flange at an edge of the opening, and the first flange partially overlaps with the edge member to shield a gap between the edge member and the first isolating member.

In some embodiments, two surfaces of the rotation table and the second heating body that face each other are a conical concave surface and a conical convex surface and are arranged at an interval, and an inlet channel is arranged in the second heating body for introducing a rotating drive gas into a gap between the conical concave surface and the conical convex surface to drive the rotation table to rotate.

In some embodiments, the first isolating member includes two first sub-isolating members, one second sub-isolating member, and two third sub-isolating members arranged around the carrier device, the two first sub-isolating members, the one second sub-isolating member, and the two third sub-isolating members cooperate to form the opening, wherein:
the two first sub-isolating members are located on an upstream side of the gas flow direction and symmetrically arranged relative to a radial centerline of the carrier device parallel to the gas flow direction;
the second sub-isolating member is located on a downstream side of the gas flow direction and in a central area of the reaction space;
the two third sub-isolating members are located on the downstream side of the gas flow direction on two edge areas on two sides of the central area of the reaction space and are symmetrically arranged relative to the radial centerline of the carrier device parallel to the gas flow direction; and
the second sub-isolating member and the second heating body form an intermediate exhaust channel, and gaps between the two third sub-isolating members and the second sub-isolating member form edge exhaust channels, an inlet end of the intermediate exhaust channel and inlet ends of the edge exhaust channels communicate with to the gap between the conical concave surface and conical convex surface, and an outlet end of the intermediate exhaust channel and outlet ends of the edge exhaust channels are located at one end of the second sub-isolating member away from the carrier device.

In some embodiments, a second flange is arranged at an edge of the second sub-isolating member neighboring to a third sub-isolating member, the second flange partially overlaps with the third sub-isolating member to shield a gap between the second sub-isolating member and the third sub-isolating member.

In some embodiments, the first isolating member includes a first inclined surface and a second inclined surface, the first inclined surface is located upstream of the gas flow direction and is joined with a lower end of the inlet opening, and a distance between the first inclined surface and the second isolating member gradually decreases along the gas flow direction; and
the second inclined surface is located downstream of the gas flow direction and is joined with a lower end of the outlet opening, and a distance between the second inclined surface and the second isolating member gradually increases along the gas flow direction.

In some embodiments, an opening size of the outlet opening gradually increases along the gas flow direction, and a minimum opening size of the outlet opening is equal to an opening size of a conjunction of the reaction space with the outlet opening.

In some embodiments, the second isolating member includes a thermally conductive isolating plate made of a thermally conductive material and an isolating layer covering an entire outer surface of the thermally conductive isolating plate.

In some embodiments, the thermally conductive material is graphite, and a material used for the isolating layer includes silicon carbide.

In some embodiments, the second isolating member and the third isolating member both include insulating isolating plates made of an insulating material.

In some embodiments, the first heating body and the second heating body are heated in an induction heating method, the first heating body and the second heating body both include a flat member and an arc member, and the flat member of the first heating body and the flat member of the second heating body are arranged at an interval opposite to each other, the flat member and the arc member form a hollow chamber, and at least one isolating layer is arranged in the hollow chamber to isolate the hollow chamber to form a plurality of sub-hollow chambers, and the isolating layer is configured to cause heating temperatures at different positions of the first heating body and the second heating body to be consistent.

In some embodiments, the insulating chamber is a cylindrical chamber formed by two semi-annular insulating covers and two disk-shaped insulating covers that are joined with each other.

As another technical solution, the present disclosure also provides semiconductor processing equipment, including a reaction chamber and an induction coil for heating the reaction chamber, the reaction chamber adopts the reaction chamber of the present disclosure, wherein the induction coil is wound externally around the insulating chamber and is configured for inductively heating the first heating body and the second heating body.

In some embodiments, the semiconductor processing equipment is applied to an epitaxial growth process.

The present disclosure has the following beneficial effects.

In the reaction chamber of the present disclosure, by accommodating the first heating body and the second heating body within the insulating chamber, the heat exchange between the first heating body and the second heating body and the external environment can be reduced to maintain the internal temperature. Meanwhile, by arranging the insulation protection structure in the insulating chamber, a reaction chamber can be enclosed between the first heating body and the second heating body, and the first heating body and the second heating body can be isolated from the reaction chamber to prevent the first heating body and the second heating body from directly contacting the reaction space. Thus, the by-product attached to the first heating body and the second heating body can be reduced, the replacement frequency of the heating body can be reduced, the equipment maintenance efficiency can be improved, and the equipment maintenance cost can be reduced.

The semiconductor processing equipment of the present disclosure can be configured to prevent the first heating body and the second heating body from directly contacting the reaction space. Thus, the by-product attached to the first heating body and the second heating body can be reduced, the replacement frequency of the heating body can be reduced, the equipment maintenance efficiency can be improved, and the equipment maintenance cost can be reduced.

### BRIEF DESCRIPTION OF THE DRAWINGS

FIG. 1 illustrates a schematic structural diagram of an isolation chamber according to embodiments of the present disclosure.
FIG. 2 illustrates a schematic exploded structural diagram of an isolation chamber according to embodiments of the present disclosure.
FIG. 3A illustrates a schematic cross-section diagram of a reaction chamber in a vertical direction according to embodiments of the present disclosure.
FIG. 3B illustrates a schematic structural diagram of a first heating body and a second heating body according to embodiments of the present disclosure.
FIG. 4 illustrates a schematic internal structural diagram of a reaction chamber according to embodiments of the present disclosure.
FIG. 5 illustrates a schematic cross-section diagram of a reaction chamber in a horizontal direction according to embodiments of the present disclosure.
FIG. 6 illustrates a schematic internal exploded structural diagram of a reaction chamber according to embodiments of the present disclosure.
FIG. 7 illustrates a schematic cross-section diagram of a carrier device in a vertical direction according to embodiments of the present disclosure.
FIG. 8 illustrates a schematic cross-section diagram of a first isolating member in a vertical direction according to embodiments of the present disclosure.
FIG. 9 illustrates a schematic zoomed-in diagram of area I in FIG. 8.
FIG. 10 illustrates a schematic zoomed-in diagram of area II in FIG. 8.
FIG. 11 illustrates a schematic cross-section diagram of a rotation plate in a vertical direction according to embodiments of the present disclosure.
FIG. 12 illustrates a schematic cross-section diagram of a second heating body in a vertical direction according to embodiments of the present disclosure.
FIG. 13 illustrates a schematic top view of a second heating body according to embodiments of the present disclosure.
FIG. 14 illustrates a schematic cross-section diagram of a second heating body in a horizontal direction according to embodiments of the present disclosure.
FIG. 15 illustrates a schematic diagram showing a flow path of a gas that is driven by rotation in a vertical direction according to embodiments of the present disclosure.
FIG. 16 illustrates a schematic diagram showing a flow path of a gas that is driven by rotation in a horizontal direction according to embodiments of the present disclosure.
FIG. 17 illustrates a schematic structural diagram of a second sub-isolating member and a third sub-isolating member according to embodiments of the present disclosure.
FIG. 18 illustrates a schematic structural diagram of a second sub-isolating member according to embodiments of the present disclosure.
FIG. 19 illustrates a schematic structural diagram showing a first inclined surface and a second inclined surface of a first isolating member according to embodiments of the present disclosure.
FIG. 20 illustrates a schematic diagram showing a flow path of a reaction gas according to embodiments of the present disclosure.
FIG. 21 illustrates a schematic structural diagram showing an outlet opening at a heat isolation cover in a circular plate shape according to embodiments of the present disclosure.
FIG. 22 illustrates a schematic structural diagram of an isolation layer according to embodiments of the present disclosure.

### DETAILED DESCRIPTION OF THE EMBODIMENTS

To cause those skilled in the art to better understand the technical solutions of the present disclosure, a reaction chamber and semiconductor processing equipment of the present disclosure are described in detail in connection with the accompanying drawings.

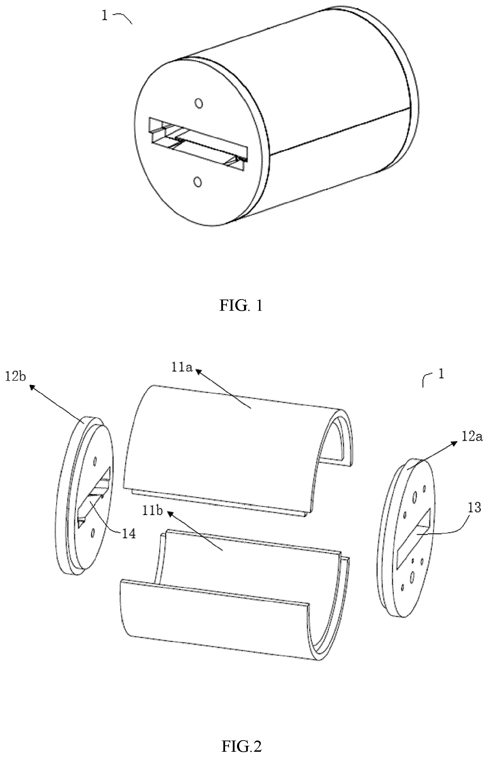

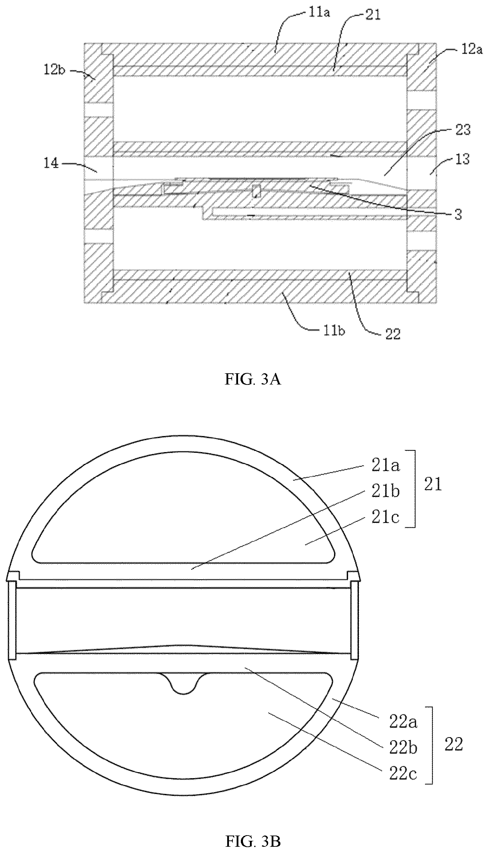

Referring to FIG. 1 to FIG. 4, a reaction chamber of embodiments of the present disclosure is applied to the semiconductor processing equipment and includes a thermal insulating chamber 1, a first heating body 21, a second heating body 22, and an isolation protection structure 4. As shown in FIG. 3A, the first heating body 21 and the second heating body 22 are arranged at an interval in the thermal insulating chamber 1. The second heating body 22 is provided with a carrier device 3 for carrying a wafer. By arranging the first heating body 21 and the second heating body 22 within the thermal insulating chamber 1, the thermal insulating chamber 1 can be configured to reduce heat exchange between the first heating body 21 and the second heating body 22 with the external environment to maintain the internal temperature, i.e., insulation function. The thermal insulating chamber 1 is preferably made of a material with low thermal conductivity and a good insulation effect.

In some embodiments, to facilitate installation and maintenance of the equipment, as shown in FIG. 2, the thermal insulating chamber 1 is a cylindrical chamber formed by joining two semi-annular insulating covers (11a, 11b) and two disc-shaped insulating covers (12a, 12b). Of course, in practical applications, the thermal insulating chamber 1 can also be formed by a plurality of individual bodies joined in any other suitable methods, and the thermal insulating chamber 1 can also adopt a chamber with any other shapes according to specific requirements.

As shown in FIG. 3A, the first heating body 21 and the second heating body 22 are arranged at an interval in the thermal heating chamber 1, for example, along a direction perpendicular to a carrying surface of the carrier device 3 for carrying the wafer (i.e., the vertical direction in FIG. 3A) and are configured for heating. It needs to be noted, in some embodiments, if the first heating body 21 and the second heating body 22 are configured to heat the wafer in the induction heating method, the cylindrical chamber can be conveniently mounted with the induction coil. The induction heating method can include applying alternating current (frequency ranging between 2kHz and 20kHz) to the induction coil to cause the induction coil to generate an alternating magnetic field. The heating body located in the alternating magnetic field can be made of an inductive material (e.g., graphite) and can generate an induction current to generate heat through the Joule effect. However, the present disclosure is not limited to this. In practical applications, according to different heating methods or other actual needs, the shape of the thermal insulating chamber 1 can also adopt any other shapes.

In some embodiments, as shown in FIG. 3B, the first heating body 21 and the second heating body 22 are configured to perform heating in the induction heating method. The first heating body 21 includes a flat member 21b and an arc shape 21a. The flat member 21b and the arc member 21a can enclose to form a hollow chamber 21c. Similarly, the second heating body 22 includes a flat member 22b and an arc member 22a. The flat member 22b and the arc member 22a can enclose to form a hollow chamber 22c. Moreover, the flat member 21b of the first heating body 21 and the flat member 22b of the second heating body 22 are arranged at an interval. The shapes of the flat member 21b of the first heating body 21 and the flat member 22 of the second heating body 22 can be more suitable for defining chamber walls of the reaction chamber to generate a good heat exchange effect. The shapes of the arc member 21a of the first heating body 21 and the arc member 22a of the second heating body 22 can match the shape of the induction coil (e.g., a perspective spiral coil). Thus, the first heating body 21 and the second heating body 22 can be close to the induction coil as much as possible to generate a good magnetic coupling effect. In addition, the hollow chamber 21c of the first heating body 21 and the hollow chamber 22c of the second heating body 22 can be configured to reduce the weight of the heating body to reduce the thermal inertia of the heating body.

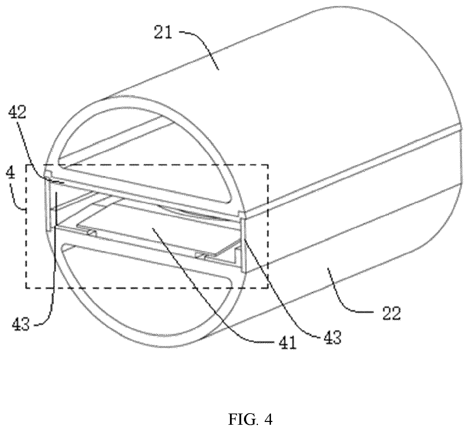

As shown in FIG. 3A and FIG. 4, an isolation protection structure 4 is arranged in the thermal insulating chamber 1 between the first heating body 21 and the second heating body 22. This isolation protection structure 4 encloses to form a reaction space 23 and separates the first heating body 21 and the second heating body 22 from the reaction space 23. The isolation protection structure 4 includes an opening on a side of the isolation protection structure 4 close to the second heating body 22 and can be configured to accommodate the carrier device 3. The carrying surface of the carrier device 3 can be exposed in the reaction space 23.

By arranging the isolation protection structure 4 in the insulating chamber 1, the first heating body 21 and the second heating body 22 can enclose to form the reaction space 23 to separate the first heating body 21 and the second heating body 22 from the reaction space 23 to prevent the first heating body 21 and the second heating body 22 from directly contacting the reaction space 23. Thus, the reaction by-product attached to the first heating body 21 and the second heating body 22 can be reduced, the exchange rate of the heating body can be reduced, the equipment maintenance efficiency can be improved, and the equipment maintenance cost can be reduced.

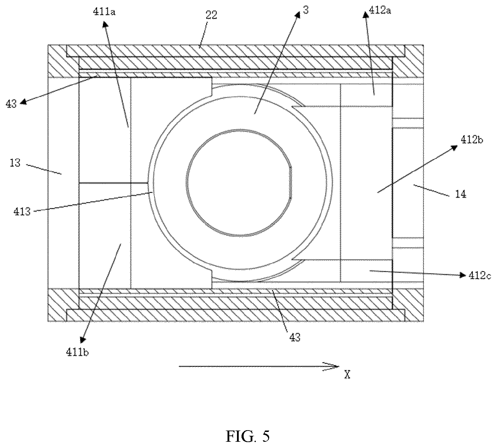

In some embodiments, as shown in FIG. 4, to facilitate assembly and maintenance of the equipment, the isolation protection structure 4 includes a first isolating member 41, a second isolating member 42, and a third isolating member 43. The first isolating member 41 is arranged on the second heating body 22 and is configured to cover the surface of the second heating body 22 neighboring to the reaction space 23. The first isolating member 41 includes the opening of the isolation protection structure 4. The second isolating member 42 is arranged on the first heating body 21 and is configured to cover the surface of the first heating body 21 neighboring to the reaction space 23. As shown in FIG. 3A, an inlet opening 13 and an outlet opening 14 are arranged at two sidewalls on two sides of the thermal insulating chamber 1. The inlet opening 13 and the outlet opening 14 communicate with the reaction space 23. In some embodiments, as shown in FIG. 2, the inlet opening 13 and the outlet opening 14 are arranged at two disc-shaped insulating covers (12a, 12b), respectively. As shown in FIG. 4, two third isolating members 43 are provided. The two third isolating members 43 are arranged on two sides of the carrier device 3 at an interval. The third isolating members 43 each connect between the second isolating member 42 and the second heating body 22 and extend along the gas flow direction from the inlet opening 13 to the outlet opening 14. The gas flow direction is the X direction shown in FIG. 5.

In some embodiments, the second isolating member 42 can include a thermal-conductive isolation plate made of a thermal-conductive material and an isolation layer covering the entire outer surface of the thermal-conductive isolation plate. In some embodiments, the thermal-conductive material can be graphite. The material of the isolation layer can include silicon carbide. With the isolation layer, the graphite can be prevented from directly contacting the reaction space 23 to reduce the falling of the particles and powders.

In some embodiments, the second isolating member 42 and each third isolating member 43 can include insulation isolation plates made of insulating materials. With the insulation isolation plates, the nest current generated in the first heating body 21 and the second heating body 22 can be prevented from interfering with each other.

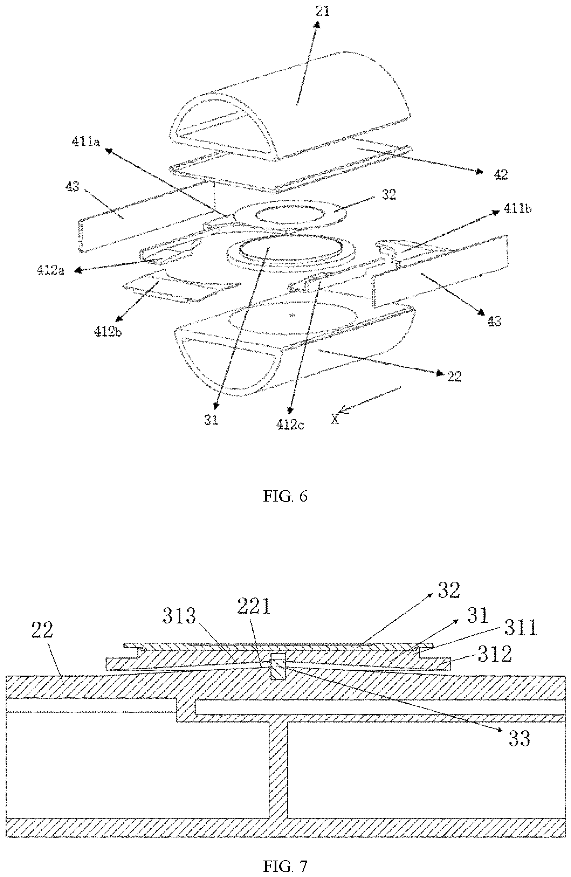

In some embodiments, as shown in FIG. 5 and FIG. 6, the first isolating member 41 includes two first sub-isolating members (411a, 41 1b) surrounding the carrier device 3, a second sub-isolating member 412b, and two third sub-isolating members (412a, 412c). The two first sub-isolating members (411a, 411b), the second sub-isolating member 412b, and the two third sub-isolating members (412a, 412c) cooperate to form the opening. The two first sub-isolating members (411a, 411b) are located on an upstream side of the gas flow direction and are symmetrically arranged relative to the radial centerline of the carrier device 3 parallel to the gas flow direction (i.e., X direction). The second sub-isolating member 412b is located on the downstream side of the gas flow direction and in the center area of the reaction space 23. The two third sub-isolating members (412a, 412c) are located on a downstream side of the gas flow direction and on two edge areas on two sides of the center area in the reaction space 23 and are symmetrically arranged relative to the radial centerline of the carrier device 3 parallel to the gas flow direction (i.e., X direction). For example, the two third isolating members (412a, 412c) are located on two sides of the second sub-isolating member 412b.

By dividing the first isolating member 41 into a plurality of sub-isolating members, according to the by-products attached to the sub-isolating members in the chamber, sub-isolating members with relatively a lot of by-products can be exchanged. Thus, the first isolating member 41 may not need to be exchanged as a whole, which improves the maintenance efficiency and reduces the maintenance cost. Thus, theoretically, when more sub-isolating members are provided, the exchange can be more convenient, and the maintenance cost can be lower. In some embodiments, 5 sub-isolating members can be provided, i.e., two first sub-isolating members (411a, 411b), a second isolating member 412b, and two third isolating members (412a, 412c). By generally considering the processing performance, the economic benefit, and processing difficulty, the two first sub-isolating members (411a, 41 1b), the second isolating member 412b, and the two third isolating members (412a, 412c) can be a preferred choice.

In some embodiments, as shown in FIG. 7, the carrier device 3 includes a rotation table 31 and a carrier plate 32 arranged on the rotation table 31 configured to carrier the wafer. The carrier plate 32 is located within the opening of the first isolating member 41 and is rotatably connected to the second heating body 22 through a rotating shaft 33. During the processing process, the rotation table 31 can be driven to rotate to drive the carrier plate 32 on the rotation table 31 to rotate, which improves the processing uniformity. Moreover, a protrusion table 311 is arranged at the rotation plate 31, and the carrier plate 32 is arranged on the protrusion table 311. The rotation table 31 includes an edge member 312 protruding from an outer peripheral wall relative to the protrusion table 311.

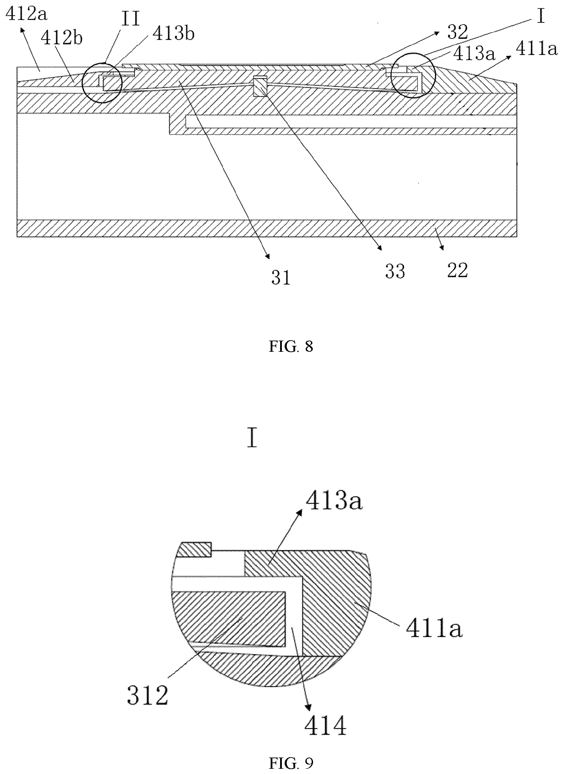

In some embodiments, as depicted in FIG. 8 to FIG. 10, the first isolating member 41 is provided with a first flange along the edge of the opening. In some embodiments, as shown in FIG. 8, the first flange partially overlaps with the first isolating member. The first flange, for example, includes a first sub-flange 413a arranged on the edge of the two first sub-isolating members (411a, 411b) and a second sub-flange 413b arranged at the edge of the second sub-isolating member 412b. The first sub-flange 413a and the second sub-flange 413b partially overlap with the edge member 312 of the rotation table 31 to shield a gap 414 between the edge member 312 and the first isolating member 41. With the first flange, the second heating body 22 can be ensured to be covered entirely to further prevent the second heating body 22 from being attached to the by-product.

It should be noted that, in practical applications, according to different structures of the first isolating members 41, the structure of the first flange can be adaptively adjusted, as long as the gap 414 between the edge member 312 of the rotation table 31 and the first isolating member 41 can be shielded.

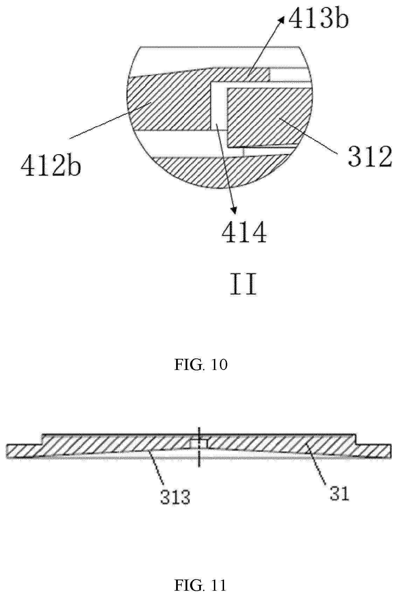

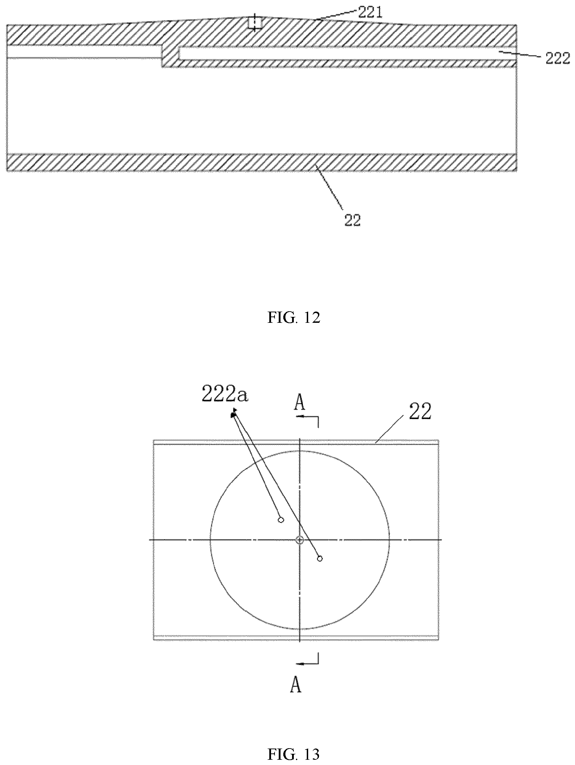

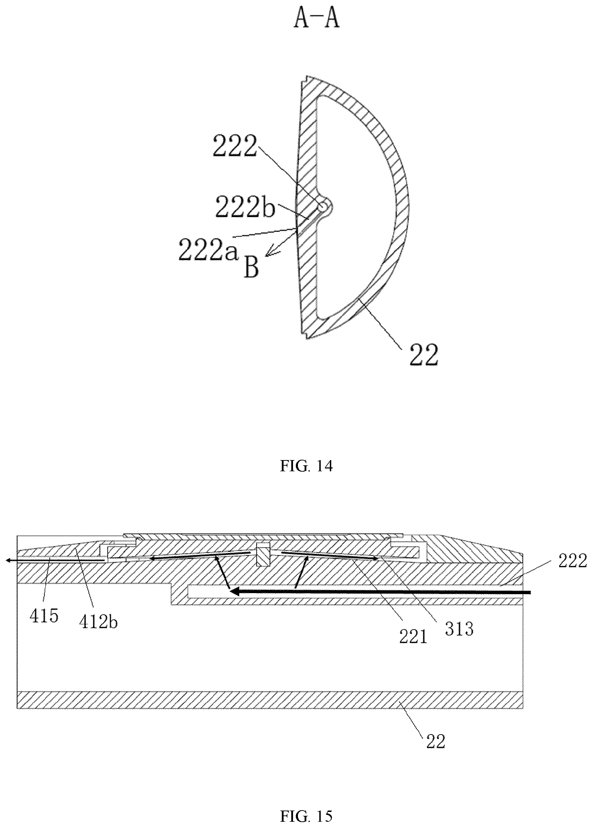

In some embodiments, as shown in FIG. 11 to FIG. 14, two surfaces of the rotation table 31 and the second heating body 22 that are opposite each other are a conical concave surface 313 and a conical convex surface 221, respectively, and are arranged at an interval. An inlet channel 222 is formed in the second heating body 22 to introduce rotating drive gas into the gap between the conical concave surface 313 and conical convex surface 221 to drive the rotation table 31 to rotate. In some embodiments, as shown in FIG. 13 and FIG. 14, the inlet channel 222 communicates with the gap between the conical concave surface 313 and the conical convex surface 221 through the plurality of exhaust holes 222b arranged at the second heating body 22. FIG. 13 shows that outlet ends of two exhaust holes 222b are at the conical convex surface 221 and are distributed symmetrically relative to the center of the conical convex surface 221. As shown in FIG. 14, an axis of an exhaust hole 222b has an angle with the vertical direction perpendicular to the carrying surface. The rotating drive gas can pass through the inlet channel 222 and the plurality of exhaust holes 222b in sequence, flow into the gap between the conical concave surface 313 and the conical convex surface 221 along inclined direction B, and drive the rotation table 31 to rotate. In some embodiments, a groove for placing the carrier plate 32 can be formed on the drive rotation table 31 to limit the position of the carrier plate 32.

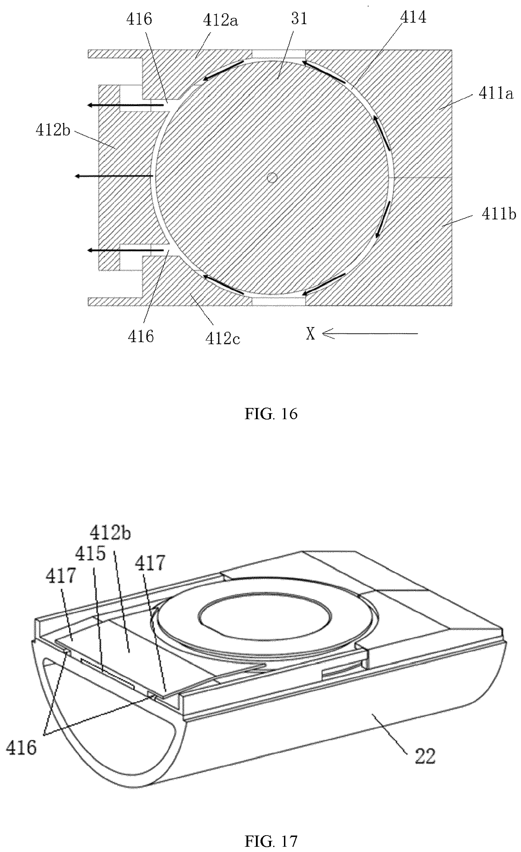

By using the conical concave surface 313 and the conical convex surface 221, the rotating drive gas therebetween can flow from the center of the rotation plate 31 toward the surrounding edge inclined downward into the gap 414 between the edge member 312 for shielding the rotation plate 31 and the first isolating member 41. As shown in FIG. 16, since a pressure difference exists on two sides along the gas flow direction (i.e., direction X) in the reaction space 23, the rotating drive gas flows along the circumferential direction of the gap 414 to drive the rotation table 31 to rotate. Meanwhile, by causing the rotating drive gas to flow from the center of the rotation table 31 to the surrounding edge inclined downward, the flow channel of the rotating drive gas can be ensured to be independent of the reaction space 23, which reduces the possibility of the rotating drive gas flowing into the reaction space 23 through the gap 414. Thus, the interference of the rotating drive gas on the reaction gas in the reaction space 23.

In some embodiments, as shown in FIG. 15, the second sub-isolating member 412b and the second heating body 22 form an intermediate exhaust channel 415. As shown in FIG. 16, the gaps between the second sub-isolating member 412b and the two neighboring third sub-isolating members (412a, 412c) form edge exhaust channels 416. An inlet end of the intermediate exhaust channel 415 and inlet ends of the edge exhaust channels 416 communicate with the interval between the conical concave surface and the conical convex surface. As shown in FIG. 17, an outlet end of the intermediate exhaust channel 415 and outlet ends of the edge exhaust channels 416 are on an end of the first isolating member 41 (i.e., the second sub-isolating member 412b) away from the carrier device 3. As shown in FIG. 16, the rotating drive gas flowing into the interval between the conical concave surface 313 and the conical convex surface 221 flows to the gap 414 between the edge member 312 and the first isolating member 41, and then can be exhausted through the intermediate exhaust channel 415 and the edge exhaust channel 416.

The intermediate exhaust channel 415 and the edge exhaust channels 416 are independent of the reaction space 23. Thus, the possibility of rotating drive gas flowing into the reaction space 23 through the gap 414 can be reduced, and the interference of the rotating drive gas on the reaction gas in the reaction space 23 can be reduced.

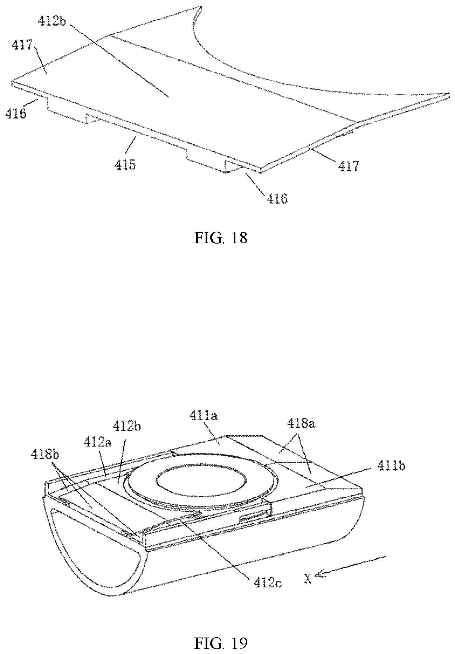

In some embodiments, as shown in FIG. 17 and FIG. 18, second flanges 417 are formed on two sides of the second sub-isolating member 412b neighboring to the two third sub-isolating members (412a, 412c). The second flanges 417 can partially overlap with the two neighboring third sub-isolating members (412a, 412c) to shield the gap between the second sub-isolating member 412b and the neighboring third sub-isolating members. Thus, the possibility of the rotating drive gas flowing into the reaction space 23 can be further reduced, and the interference of the rotating drive gas on the reaction gas in the reaction space 23 can be reduced.

In some embodiments, as shown in FIG. 18, the structure of the intermediate exhaust channel 415 includes, for example, a groove formed on the surface of the second sub-isolating member 412b facing the second heating body 22. The groove and the second heating body 22 form the intermediate exhaust channel 415. However, the present disclosure is not limited to this. In practical applications, the groove can also be formed on the second heating body 22 or the grooves can also be formed on the surfaces of the second sub-isolating member 412b and the second heating body 22 facing each other.

In some embodiments, as shown in FIG. 19, the surface of the first isolating member 41 includes a first inclined surface 418a and a second inclined surface 418b. In some embodiments, the first inclined surface 418a and the second inclined surfaces 418b are neighboring to the reaction space 23. The first inclined surface 418a is formed by two inclined sub-surfaces of the two first sub-isolating members (411a, 411b), and the second inclined surfaces 418b are formed by an inclined sub-surface of the second sub-isolating member 412b and inclined sub-surfaces of the two third sub-isolating members (412a, 412c). The first inclined surface 418a is located upstream of the gas flow direction (i.e., direction X) and abuts the lower end of the inlet opening 13. The distance between the first inclined surface 418a and the second isolating member 42 gradually decreases along the gas flow direction. The second inclined surface 418b is located downstream of the gas flow direction and abuts the lower end of the outlet opening 14. The distance between the second inclined surface 418b and the second isolating member 42 gradually increases along the gas flow direction.

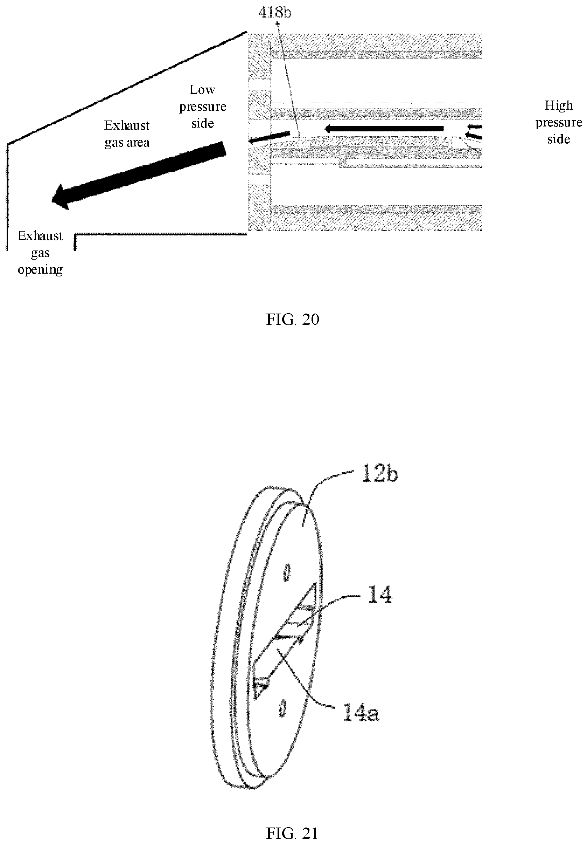

As shown in FIG. 20, with the first inclined surface 418a, the reaction gas flowing in from the inlet opening 13 enters the reaction space 23 along an upward inclined direction. Thus, the reaction gas can directly pass through the gap 414 to reduce the interference between the rotating drive gas and the reaction gas. The reaction gas entering the reaction space 23 inclinedly upward can flow along a direction parallel to the carrying surface through the above of the wafer. Then, with the second inclined surface 418b, the reaction gas can flow inclinedly downward to the outlet opening 14. Thus, the gas after the reaction can be directly exhausted, which reduces the gas interference in the tail gas area when the reaction gas flows out horizontally and reduces the contamination possibility of the wafer caused by the particles and powder.

In some embodiments, the opening size of the outlet opening 14 can gradually increase along the gas flow direction, and the minimum opening size of the outlet opening 14 can be equal to the opening size at the j unction of the opening of the reaction space 23 with the outlet opening 14. Thus, the gas flow direction can be maintained unchanged when the reaction gas flowing into the outlet opening 14 to further reduce the gas interference in the tail gas area. In some embodiments, as shown in FIG. 21, a wedge-shaped protrusion 14a is formed at the bottom surface of the outlet opening 14. The wedge-shaped protrusion 14a includes an inclined surface. As shown in FIG. 3A, the inclined surface and the second inclined surface 418b form a continuous inclined surface to further reduce the gas interference in the tail gas area.

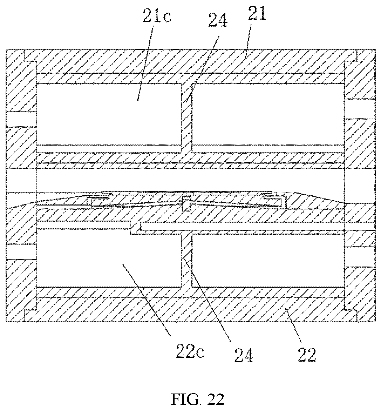

In some embodiments, as shown in FIG. 22, at least one isolation layer 24 is arranged in the hollow chamber 21c of the first heating body 21 and the hollow chamber 22c of the second heating body 22 to isolate the hollow chambers to form a plurality of sub-hollow chambers. The isolation layer 24 can be configured to cause the heating temperatures at different positions of the first heating body 21 and the second heating body 22 to be consistent. For example, as shown in FIG. 22, each of the first heating body 21 and the second heating body 22 includes an isolation layer 24 to isolate the hollow chamber of each of the first heating body 21 and the second heating body 22 into two sub-hollow chambers in a direction parallel to the gas flow direction.

With the above isolation layer 24, temperature compensation can be performed on the different areas of the carrier plate 32. In some embodiments, the isolation layer 24 can isolate the hollow chamber to form a plurality of sub-hollow chambers. Since the temperature of the position where the isolation layer 24 is located is high, by arranging the isolation layers 24 at different positions of the first heating body 21 and the second heating boy 22, the temperatures at different positions of the first heating body 21 and the second heating body 22 can be adjusted to perform temperature compensation on the different areas of the carrier plate 32. In practical applications, the number of the isolation layers 24, the isolation method of the isolation layers 24, and the positions of the isolation layers 24 in the first heating body 21 and the second heating body 22 can be set arbitrarily to cause the heating temperatures at the different positions of the first heating body 21 and the second heating body 22 to be consistent.

In some embodiments, the isolation layers 24 can be integrally formed with the first heating body 21 and the second heating body 22.

In the reaction chamber of the present disclosure, by accommodating the first heating body and the second heating body within the insulating chamber, the heat exchange between the first heating body and the second heating body and the external environment can be reduced to maintain the internal temperature. Meanwhile, by arranging the insulation protection structure in the insulating chamber, a reaction chamber can be enclosed between the first heating body and the second heating body, and the first heating body and the second heating body can be isolated from the reaction chamber to prevent the first heating body and the second heating body from directly contacting the reaction space. Thus, the by-product attached to the first heating body and the second heating body can be reduced, the replacement frequency of the heating body can be reduced, the equipment maintenance efficiency can be improved, and the equipment maintenance cost can be reduced.

As another technical solution, the present disclosure further provides semiconductor processing equipment, including a reaction chamber and an induction coil for heating the reaction chamber. The reaction chamber can adopt the reaction chamber of the present disclosure. The induction coil can be wound externally around the insulating chamber. Thus, the first heating body and the second heating body can heat the reaction space in the induction heating method.

In some embodiments, the semiconductor processing equipment can be applied to an epitaxial growth process.

In the semiconductor processing equipment of the present disclosure, by adopting the reaction chamber of the present disclosure, the first heating body and the second heating body can be prevented from directly contacting the reaction space to reduce the by-product attached to the first heating body and the second heating body. Thus, the replacement frequency of the heating body can be reduced, the equipment maintenance efficiency can be improved, and the equipment maintenance cost can be reduced.

It can be understood that the above embodiments are merely illustrative examples used to explain the principles of the present disclosure. However, the present disclosure is not limited to this. Those skilled in the art can make various modifications and improvements without departing from the spirit and essence of the present disclosure, and such modifications and improvements are also within the scope of the present disclosure.

## Claims

1. A reaction chamber applied to semiconductor processing equipment comprising an insulating chamber, a first heating body, a second heating body, and an isolation protection structure, wherein:
the first heating body and the second heating body are arranged in the insulating chamber at an interval, and a carrier device for carrying a wafer is arranged on the second heating body; and
the isolation protection structure is arranged in the insulating chamber, located between the first heating body and the second heating body, forms a reaction space, and isolates the first heating body and the second heating body from the reaction space, an opening is arranged on a side of the isolation protection structure close to the second heating body and is configured to accommodate the carrier device, and a carrying surface of the carrier device is exposed in the reaction space.

2. The reaction chamber according to claim 1, wherein the isolation protection structure includes a first isolating member, a second isolating member, and a third isolating member, wherein:
the first isolating member is arranged at the second heating body, is configured to cover a surface of the second heating body neighboring to the reaction space, and includes the opening;
the second isolating member is arranged at the first heating body and configured to cover a surface of the first heating body neighboring the reaction space; and
an inlet opening and an outlet opening are arranged on sidewalls on two sides of the insulating chamber, the inlet opening and the outlet opening communicate with the reaction space, two third isolating members are provided, the two third isolating members are arranged on two sides of the carrier device at an interval, and each third isolating member of the two third isolating members connects between the second isolating member and the second heating body and extends along a gas flow direction from the inlet opening to the outlet opening.

3. The reaction chamber according to claim 2, wherein the carrier device includes a rotation table and a carrier plate for carrying the wafer arranged on the rotation table, and the rotation table is located in the opening and rotatably connected to the second heating body through a rotating shaft; and
the rotation table includes a protrusion table, the carrier plate is arranged on the protrusion table, the rotation table includes an edge member protruding relative to an outer peripheral wall of the protrusion table, the first isolating member includes a first flange at an edge of the opening, and the first flange partially overlaps with the edge member to shield a gap between the edge member and the first isolating member.

4. The reaction chamber according to claim 3, wherein two surfaces of the rotation table and the second heating body that face to each other are a conical concave surface and a conical convex surface and are arranged at an interval, and an inlet channel is arranged in the second heating body for introducing a rotating drive gas into a gap between the conical concave surface and the conical convex surface to drive the rotation table to rotate.

5. The reaction chamber according to claim 4, wherein the first isolating member includes two first sub-isolating members, one second sub-isolating member, and two third sub-isolating members arranged around the carrier device, the two first sub-isolating members, the one second sub-isolating member, and the two third sub-isolating members cooperate to form the opening, wherein:
the two first sub-isolating members are located on an upstream side of the gas flow direction and symmetrically arranged relative to a radial centerline of the carrier device parallel to the gas flow direction;
the second sub-isolating member is located on a downstream side of the gas flow direction and in a central area of the reaction space;
the two third sub-isolating members are located on the downstream side of the gas flow direction on two edge areas on two sides of the central area of the reaction space and are symmetrically arranged relative to the radial centerline of the carrier device parallel to the gas flow direction; and
the second sub-isolating member and the second heating body form an intermediate exhaust channel, and gaps between the two third sub-isolating members and the second sub-isolating member form edge exhaust channels, an inlet end of the intermediate exhaust channel and inlet ends of the edge exhaust channels communicate with to the gap between the conical concave surface and conical convex surface, and an outlet end of the intermediate exhaust channel and outlet ends of the edge exhaust channels are located at one end of the second sub-isolating member away from the carrier device.

6. The reaction chamber according to claim 5, wherein a second flange is arranged at an edge of the second sub-isolating member neighboring to a third sub-isolating member, the second flange partially overlaps with the third sub-isolating member to shield a gap between the second sub-isolating member and the third sub-isolating member.

7. The reaction chamber according to any one of claims 2 to 6, wherein the first isolating member includes a first inclined surface and a second inclined surface, the first inclined surface is located upstream of the gas flow direction and is joined with a lower end of the inlet opening, and a distance between the first inclined surface and the second isolating member gradually decreases along the gas flow direction; and
the second inclined surface is located downstream of the gas flow direction and is joined with a lower end of the outlet opening, and a distance between the second inclined surface and the second isolating member gradually increases along the gas flow direction.

8. The reaction chamber according to claim 7, wherein a opening size of the outlet opening gradually increases along the gas flow direction, and a minimum opening size of the outlet opening is equal to an opening size of a conjunction of the reaction space with the outlet opening.

9. The reaction chamber according to claim 2, wherein the second isolating member includes a thermally conductive isolating plate made of a thermally conductive material and an isolating layer covering an entire outer surface of the thermally conductive isolating plate.

10. The reaction chamber according to claim 9, wherein the thermally conductive material is graphite, and a material used for the isolating layer includes silicon carbide.

11. The reaction chamber according to claim 2, wherein the second isolating member and the third isolating member both include insulating isolating plates made of an insulating material.

12. The reaction chamber according to claim 1, wherein the first heating body and the second heating body are heated in an induction heating method, the first heating body and the second heating body both include a flat member and an arc member, and the flat member of the first heating body and the flat member of the second heating body are arranged at an interval opposite to each other, the flat member and the arc member form a hollow chamber, and at least one isolating layer is arranged in the hollow chamber to isolate the hollow chamber to form a plurality of sub-hollow chambers, and the isolating layer is configured to cause heating temperatures at different positions of the first heating body and the second heating body to be consistent.

13. The reaction chamber according to claim 1 or 12, wherein the insulating chamber is a cylindrical chamber formed by two semi-annular insulating covers and two disk-shaped insulating covers that are j oint with each other.

14. Semiconductor processing equipment comprising a reaction chamber and an induction coil for heating the reaction chamber, the reaction chamber adopts the reaction chamber according to any one of claims 1 to 13, wherein the induction coil is wound externally around the insulating chamber and is configured for inductively heating the first heating body and the second heating body.

15. The semiconductor processing equipment according to claim 14, wherein the semiconductor processing equipment is applied to an epitaxial growth process.
